# EUROPEAN PATENT APPLICATION

(11) **EP 4 641 228 A1**
(43) Date of publication of application: **29.10.2025**
(21) Application number: 23926788.3
(22) Date of filing: 15.03.2023
(51) Int. Cl.: G01R 31/36, G01R 19/00, B60L 58/10, H01M 10/42

(54) **HIGH-VOLTAGE SAMPLING CIRCUIT, HIGH-VOLTAGE SAMPLING METHOD, AND BATTERY MANAGEMENT SYSTEM**

(71) Applicant: ZHEJIANG ZEEKR INTELLIGENT TECHNOLOGY CO., LTD., Ningbo, Zhejiang 315899 (CN); VIRIDI E-MOBILITY TECHNOLOGY (NINGBO) CO., LTD., Ningbo, Zhejiang 315336 (CN); Zhejiang Geely Holding Group Co., Ltd., Hangzhou, Zhejiang 310051 (CN)
(72) Inventor: YANG, Bo, Ningbo, Zhejiang 315899 (CN); CHEN, Deting, Ningbo, Zhejiang 315899 (CN); LIU, Gang, Ningbo, Zhejiang 315899 (CN); CHEN, Xiao, Ningbo, Zhejiang 315899 (CN); LV, Yang, Ningbo, Zhejiang 315899 (CN); HE, Yangfan, Ningbo, Zhejiang 315899 (CN); NIU, Yaqi, Ningbo, Zhejiang 315899 (CN)
(74) Representative: Michalski Hüttermann & Partner Patentanwälte mbB
(86) International application number: PCT/CN2023/081753
(87) International publication number: WO 2024/187433

(57) **Abstract**

A high-voltage sampling circuit, comprising: a high-voltage MOS tube (201) and a battery sampling device (202), wherein an output end of the battery sampling device (202) is connected to a gate electrode of the high-voltage MOS tube (201), so as to output a high level or a low level; an analog-to-digital conversion end of the battery sampling device (202) is connected to a source electrode of the high-voltage MOS tube (201), so as to collect a voltage of the source electrode of the high-voltage MOS tube (201); a drain electrode of the high-voltage MOS tube (201) is connected to a positive electrode of a battery pack by means of a first voltage-dividing resistor (203), and the source electrode of the high-voltage MOS tube (201) is connected to a negative electrode of the battery pack by means of a second voltage-dividing resistor (204); and the battery sampling device (202) is used for collecting a voltage across the high-voltage MOS tube (201) when the high level is outputted to the high-voltage MOS tube (201), and converting the voltage, so as to obtain a power supply voltage of the battery pack. Compared with an optical coupler, a high-voltage MOS tube serving as an electronic switch for high-voltage sampling can reduce costs. A high-voltage sampling method and a battery management system are further involved.

## Description

### TECHNICAL FIELD

The present disclosure relates to the field of battery technologies, and in particular, to a high-voltage sampling circuit, a high-voltage sampling method, and a battery management system.

### BACKGROUND

A battery pack is one of the three most important components in new energy vehicles. To ensure safety of vehicle users during vehicle operation and charging, high-voltage sampling circuits are required to sample connection status of relays and other components in the high-voltage circuit of the battery pack so as to ensure that the electronic control units in new energy vehicles can perform safe charging and discharging operations and achieve efficient energy utilization. In high-voltage sampling circuits, new energy vehicle manufacturers commonly use optocouplers as electronic switches, but the cost of optocouplers is relatively high.

### SUMMARY

The present disclosure provides a high-voltage sampling circuit, a high-voltage sampling method, and a battery management system to address deficiencies in the related art.

According to a first aspect of the embodiments of the present disclosure, a high-voltage sampling circuit is provided. The circuit is configured to collect a voltage of a battery pack. A positive electrode of the battery pack is connected to a positive relay, and a negative electrode of the battery pack is connected to a negative relay. The circuit includes: a high-voltage MOS transistor and a battery sampling device.

An output terminal of the battery sampling device is connected to a gate of the high-voltage MOS transistor and is configured to output a high level or a low level;

An analog-to-digital conversion terminal of the battery sampling device is connected to a source of the high-voltage MOS transistor and is configured to collect a voltage at the source of the high-voltage MOS transistor.

A drain of the high-voltage MOS transistor is connected to the positive electrode of the battery pack through a first voltage-dividing resistor, and the source of the high-voltage MOS transistor is connected to the negative electrode of the battery pack through a second voltage-dividing resistor.

The battery sampling device is configured to collect the voltage passing through the high-voltage MOS transistor when outputting a high level to the high-voltage MOS transistor and convert the voltage to obtain a supply voltage of the battery pack.

In some embodiments, the gate of the high-voltage MOS transistor is connected to one end of a third voltage-dividing resistor, and other end of the third voltage-dividing resistor is connected to the output terminal of the battery sampling device.

The gate of the high-voltage MOS transistor is connected to one end of a fourth voltage-dividing resistor, and other end of the fourth voltage-dividing resistor is grounded.

In some embodiments, the circuit further includes: a filter circuit configured to filter the voltage collected by the battery sampling device.

A filter current-limiting resistor in the filter circuit is connected in series between the source of the high-voltage MOS transistor and the analog-to-digital conversion terminal of the battery sampling device.

One end of a filter capacitor in the filter circuit is connected to the analog-to-digital conversion terminal of the battery sampling device, and other end of the filter capacitor is grounded.

In some embodiments, the circuit further includes: a shunt.

A first end of the shunt is connected to the negative electrode of the battery pack, a second end of the shunt is connected to the negative relay, and a third end of the shunt is connected to a current sampling pin of the battery sampling device.

The battery sampling device is configured to collect a current passing through the shunt.

In some embodiments, the first voltage-dividing resistor includes a plurality of sub-resistors connected in series.

Respective resistance values of the sub-resistors are same and/or different, and a number and the respective resistance values of the sub-resistors are determined according to a voltage value to be divided.

In some embodiments, the high-voltage MOS transistor meets at least one of following conditions:
a source-drain voltage of the high-voltage MOS transistor is greater than the supply voltage of the battery pack;
a maximum gate-source voltage of the high-voltage MOS transistor is greater than the supply voltage of the battery pack;
a distance between pins of the high-voltage MOS transistor is greater than a distance threshold.

According to a second aspect of the embodiments of the present disclosure, a high-voltage sampling method using the high-voltage sampling circuit according to any one of the above is provided. The method includes:
in response to the battery sampling device receiving a high-voltage sampling instruction, controlling the output terminal to output the high level to turn on the gate-source of the high-voltage MOS transistor;
collecting the voltage passing through the high-voltage MOS transistor using the analog-to-digital conversion terminal of the battery sampling device and converting the voltage to obtain the supply voltage of the battery pack.

In some embodiments, the method further includes:
in response to the battery sampling device receiving a current sampling instruction, collecting a current passing through the shunt from the current sampling pin.

According to a third aspect of the embodiments of the present disclosure, a battery management system is provided. The battery management system includes the high-voltage sampling circuit according to any one of the above.

According to the above embodiments, the high-voltage sampling circuit provided by the present disclosure includes: a high-voltage MOS transistor and a battery sampling device. The output terminal of the battery sampling device is connected to the gate of the high-voltage MOS transistor and is configured to output a high level or a low level. The analog-to-digital conversion terminal of the battery sampling device is connected to the source of the high-voltage MOS transistor and is configured to collect the voltage at the source of the high-voltage MOS transistor. The drain of the high-voltage MOS transistor is connected to the positive electrode of the battery pack through a first voltage-dividing resistor, and the source of the high-voltage MOS transistor is connected to the negative electrode of the battery pack through a second voltage-dividing resistor. The battery sampling device is configured to collect the voltage passing through the high-voltage MOS transistor when outputting a high level to the high-voltage MOS transistor and convert the voltage to obtain the supply voltage of the battery pack. Compared with an optocoupler, using a high-voltage MOS transistor as an electronic switch for high-voltage sampling can reduce costs.

It should be understood that the above general description and the following detailed description are merely exemplary and explanatory and are not intended to limit the present disclosure.

### BRIEF DESCRIPTION OF THE DRAWINGS

The accompanying drawings herein are incorporated into and constitute a part of this specification, illustrate embodiments consistent with the present disclosure, and together with the specification serve to explain the principles of the present disclosure.
FIG. 1 is a schematic diagram of a high-voltage sampling circuit using an optocoupler as an electronic switch according to an embodiment of the present disclosure.
FIG. 2 is a schematic diagram of a high-voltage sampling circuit using a high-voltage MOS transistor as an electronic switch according to an embodiment of the present disclosure.
FIG. 3 is a schematic diagram of a high-voltage sampling circuit including a shunt according to an embodiment of the present disclosure.
FIG. 4 is a schematic diagram of a high-voltage sampling method according to an embodiment of the present disclosure.
FIG. 5 is a specific schematic diagram of a high-voltage sampling circuit according to an embodiment of the present disclosure.

### DETAILED DESCRIPTION OF THE EMBODIMENTS

Exemplary embodiments will be described in detail herein, with examples shown in the accompanying drawings. Where the following description refers to the drawings, the same numerals in different drawings refer to the same or similar elements unless otherwise indicated. The implementations described in the following exemplary embodiments do not represent all implementations consistent with the present disclosure. On the contrary, they are merely examples of apparatuses and methods consistent with some aspects of the present disclosure as detailed in the appended claims.

The terms used in the present disclosure are for the purpose of describing specific embodiments only and are not intended to limit the present disclosure. As used in the present disclosure and the appended claims, the singular forms "a," "the," and "said" are intended to include the plural forms as well, unless the context clearly indicates otherwise. It should also be understood that the term "and/or" as used herein refers to and includes any and all possible combinations of one or more of the associated listed items.

It should be understood that although the terms first, second, third, etc. may be used in the present disclosure to describe various information, such information should not be limited to these terms. These terms are only used to distinguish information of the same type from each other. For example, without departing from the scope of the present disclosure, first information may also be referred to as second information, and similarly, second information may also be referred to as first information. Depending on the context, the word "if" as used herein may be interpreted as "when" or "upon" or "in response to determining."

An optical coupler (OC), also known as a photoelectric isolator or photoelectric coupler, is referred to as an optocoupler for short. An optocoupler is a device that transmits electrical signals using light as a medium, usually with a light emitter (infrared light-emitting diode LED) and a light receiver (photosensitive semiconductor transistor) encapsulated in a same package. When an electrical signal is applied to an input end, the light emitter emits light, and the light receiver generates a photocurrent after receiving the light, which flows out from an output end, thereby realizing "electrical-optical-electrical" conversion.

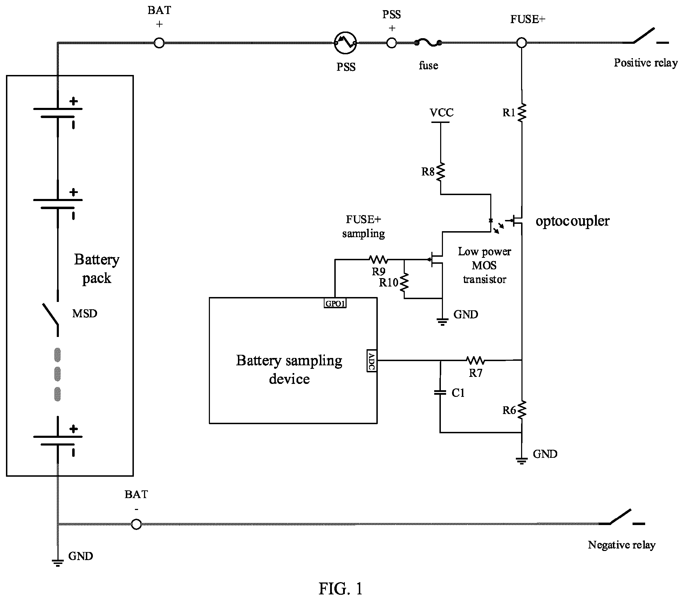

FIG. 1 is a schematic diagram of a high-voltage sampling circuit using an optocoupler as an electronic switch according to an embodiment of the present disclosure. In high-voltage sampling circuits, new energy vehicle manufacturers generally use optocouplers as electronic switches, but the cost of optocouplers is relatively high.

In view of this, embodiments of the present disclosure provide a high-voltage sampling circuit that uses a high-voltage MOS transistor as an electronic switch for high-voltage sampling. Compared with optocouplers, the use of high-voltage MOS transistors can reduce costs.

New energy vehicles are basically same in terms of high-voltage architecture design principles. On a high-voltage positive side of a battery pack, there are a pyrotechnical safety switch (PSS), referred to as pyrofuse for short, a traditional fuse FUSE, a positive relay, a pre-charge relay, a fast-charge relay, etc. The purpose is basically to reduce harm of short circuits, and at the same time, circuits can be designed to monitor voltage and status information of the aforementioned devices in real-time. Therefore, there are multiple paths for high-voltage sampling of the battery pack, and the sampling principle of each path is the same. The high-voltage sampling circuit provided by the embodiments of the present disclosure can be applied to any path.

The following embodiments will explain the high-voltage sampling circuit provided by the present disclosure in conjunction with the accompanying drawings.

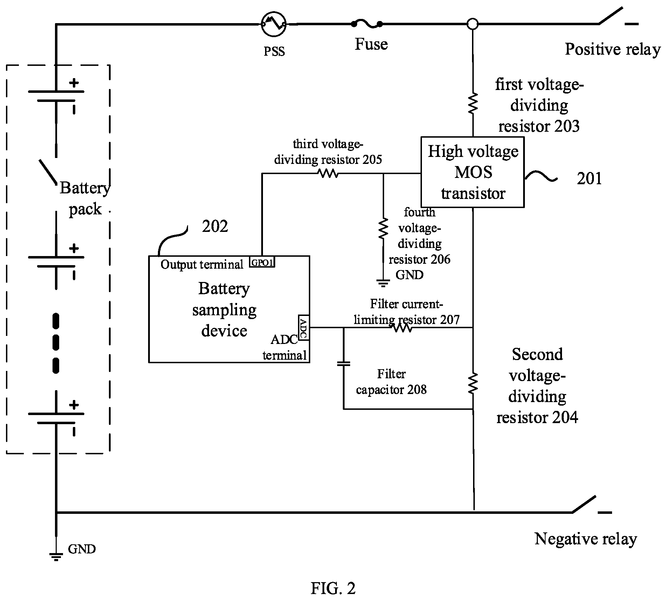

The high-voltage sampling circuit provided by the present disclosure is configured to collect the voltage of the battery pack. A positive electrode of the battery pack is connected to a positive relay, and a negative electrode of the battery pack is connected to a negative relay. FIG. 2 is a schematic diagram of a high-voltage sampling circuit using a high-voltage MOS transistor as an electronic switch according to an embodiment of the present disclosure. As shown in FIG. 2, the circuit includes: a high-voltage MOS transistor 201 and a battery sampling device 202.

An output terminal of the battery sampling device 202 is connected to a gate of the high-voltage MOS transistor 201 and is configured to output a high level or a low level.

An analog-to-digital conversion terminal of the battery sampling device 202 is connected to a source of the high-voltage MOS transistor 201 and is cofingured to collect a voltage at the source of the high-voltage MOS transistor.

A drain of the high-voltage MOS transistor 201 is connected to the positive electrode of the battery pack through a first voltage-dividing resistor 203, and the source of the high-voltage MOS transistor is connected to the negative electrode of the battery pack through a second voltage-dividing resistor 204.

The battery sampling device 202 is configured to collect a voltage across/passing through the high-voltage MOS transistor 201 when outputting a high level to the high-voltage MOS transistor 201, and convert the voltage to obtain a supply voltage of the battery pack.

The battery sampling device may include a Battery Monitor Unit (BMU) and a Circuit Supervision Control (CSC), and the CSC includes a battery sampling chip/analog front end (AFE). The AFE may include a 16-bit Analog-to-Digital Converter (ADC), a high-precision voltage reference, a high-voltage multiplexer, and a Serial Peripheral Interface (SPI). The AFE communicates with the BMU in a serial manner.

In the embodiment of the present disclosure, the output terminal of the AFE is connected to the gate of the high-voltage MOS transistor, and the analog-to-digital conversion terminal of the AFE is connected to the source of the high-voltage MOS transistor. The battery management unit BMU reads a register of the AFE through SPI communication, converts the read voltage to obtain the supply voltage of the battery pack.

In one embodiment, the AFE may adopt an AFE2950 chip. It should be understood by those skilled in the art that the AFE may also adopt other models of chips besides the AFE2950 chip, which is not limited in the present disclosure.

In some embodiments, the high level output by the battery sampling device is usually greater than a turn-on level of the high-voltage MOS transistor. To pull down the high level input to the high-voltage MOS transistor, voltage-dividing resistors may be connected in series between the high-voltage MOS transistor and the battery sampling device. As shown in FIG. 2, the gate of the high-voltage MOS transistor may be connected to one end of a third voltage-dividing resistor 205, and other end of the third voltage-dividing resistor 205 is connected to the output terminal of the battery sampling device; the gate of the high-voltage MOS transistor may be connected to one end of a fourth voltage-dividing resistor 206, and other end of the fourth voltage-dividing resistor 206 is grounded.

For example, the voltage sampling device can output a high level of 12V, and the turn-on voltage of the high-voltage MOS transistor is 4.5V. In this case, voltage division can be performed through the third voltage-dividing resistor and the fourth voltage-dividing resistor.

In some embodiments, the circuit may further include: a filter circuit configured to filter the voltage collected by the battery sampling device. As shown in FIG. 2, a filter current-limiting resistor 207 in the filter circuit is connected in series between the source of the high-voltage MOS transistor and the analog-to-digital conversion terminal of the battery sampling device; one end of a filter capacitor 208 in the filter circuit is connected to the analog-to-digital conversion terminal of the battery sampling device, and other end of the filter capacitor 208 is grounded.

In the embodiment of the present disclosure, the high-voltage sampling circuit and the BMU may be integrated on a single PCB, or the high-voltage sampling circuit and the BMU may be separated, or the high-voltage sampling and current sampling may be integrated on a single PCB, which is not limited in the present disclosure.

In some embodiments, the circuit further includes: a shunt; where a first end of the shunt is connected to the negative electrode of the battery pack, a second end of the shunt is connected to the negative relay, and a third end of the shunt is connected to a current sampling pin of the battery sampling device. The battery sampling device is configured to collect a current passing through the shunt.

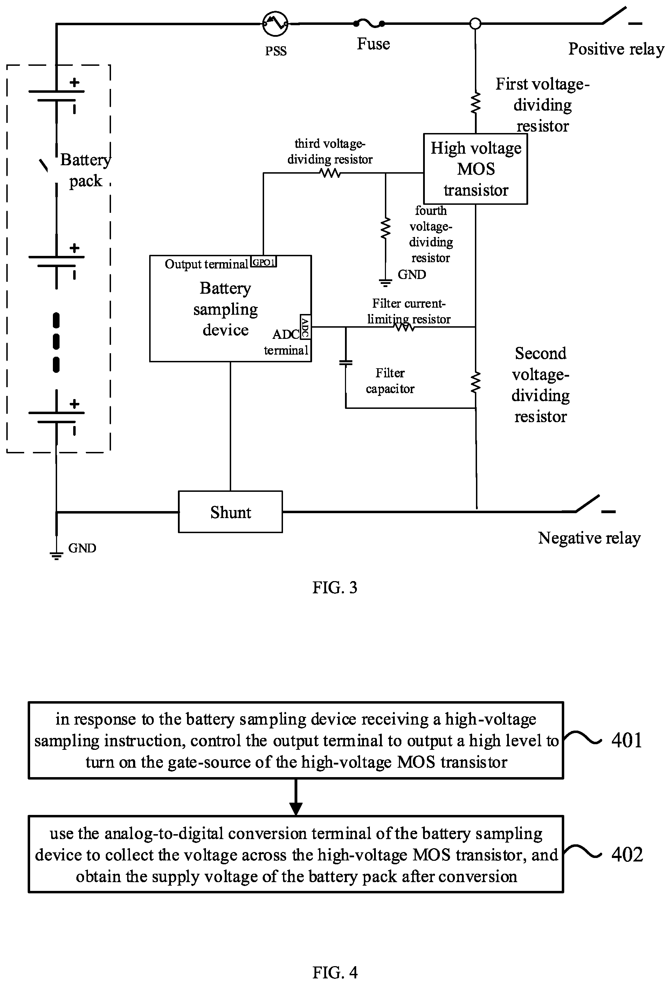

FIG. 3 is a schematic diagram of a high-voltage sampling circuit including a shunt according to an embodiment of the present disclosure. As shown in FIG. 3, the third end of the shunt may be connected to the IxA pin and IxB pin of the battery sampling device. The high-voltage sampling circuit provided by the embodiment of the present disclosure can sample both voltage and current.

In some embodiments, the first voltage-dividing resistor may include a plurality of sub-resistors connected in series. Resistance values of the sub-resistors are the same and/or different, and the number and resistance values of the sub-resistors are determined according to the voltage value to be divided.

In the embodiment of the present disclosure, the number and respective resistance values of sub-resistors in the first voltage-dividing resistor can be finally determined by comprehensively considering the supply voltage of the battery pack, an on-resistance of the high-voltage MOS transistor, and the second voltage-dividing resistor. In actual selection, voltage withstand performance of the resistor can be considered. For example, if the maximum operating voltage of a resistor is 200V, 5 to 6 resistors can be selected to meet the voltage division requirement on an 800V voltage platform. In addition, considering factors such as the voltage identification range of the ADC in the AFE and the high-voltage sampling accuracy, respective resistance values of sub-resistors can be in the MΩ level, such as 1MΩ or 2.4MΩ. For example, on an 800V voltage platform, 6 sub-resistors with a resistance value of 1MΩ can be selected.

The second voltage-dividing resistor can usually select a resistor with a resistance value in the KΩ level according to the voltage identification range of the ADC interface of the voltage sampling device. Therefore, the respective resistance values of the sub-resistors in the first voltage-dividing resistor are much larger than that of the second voltage-dividing resistor. For example, in this embodiment, the resistance value of the second voltage-dividing resistor can be 15KΩ.

When selecting the high-voltage MOS transistor in the embodiment of the present disclosure, considerations can be made from the aspects of voltage withstand performance and isolation performance of the high-voltage MOS transistor, and specifically, the selection can be made according to the following conditions.
(1) a source-drain voltage of the high-voltage MOS transistor is greater than the supply voltage of the battery pack.
   That is, from the perspective of the voltage withstand performance of the drain and source of the high-voltage MOS transistor, considering derating, the VDS (drain-source) voltage withstand of the MOS transistor should be greater than the applied platform voltage. For example, an 800V battery pack platform can select a MOS transistor with a voltage of 1000V or more.
(2) A maximum gate-source voltage of the high-voltage MOS transistor is greater than the supply voltage of the battery pack.
   The maximum gate-source voltage VESD (G-S) of the high-voltage MOS transistor is at least larger than the maximum voltage of the platform with a margin to meet ESD and other tests. Still taking the 800V battery pack platform as an example, a MOS transistor with a VESD (G-S) value of 3000V can be selected.
(3) A distance between pins of the high-voltage MOS transistor is greater than a distance threshold.
   In terms of the packaging of the high-voltage MOS transistor, the distance between the pins of the high-voltage MOS transistor needs to meet the requirements of high and low voltage isolation. For example, for a high voltage of 600V to 1000V, a device with a distance of at least 5mm between pins is selected.
(4) A leakage current of the high-voltage MOS transistor is less than a current threshold.

A large leakage current means that a sampling error will be larger when sampling in a high-temperature environment. Therefore, the smaller the leakage current of the high-voltage MOS transistor, the better. In one example, the above current threshold can be 50uA. It should be understood by those skilled in the art that the current threshold can change with the development of technology. For example, as technology advances, high-voltage MOS transistors with smaller leakage currents can be produced, and in this case, the current threshold can be adjusted as needed.

In the embodiment of the present disclosure, the on-resistance of the high-voltage MOS transistor is usually relatively small, which can be almost ignored for high-voltage circuits, so the on-resistance of the high-voltage MOS transistor may not be considered during selection.

It should be understood by those skilled in the art that the above 800V voltage platform is for illustrative purposes to explain how to select a suitable high-voltage MOS transistor and should not be construed as a limitation to the present disclosure. For voltage platforms above 800V, a suitable high-voltage MOS transistor can still be selected according to the above selection conditions.

The following embodiments will compare the performance of high-voltage MOS transistors and optocouplers as electronic switches.

The following table compares high-voltage MOS transistors and optocouplers in high-voltage sampling circuits from different perspectives.

| | High-voltage MOS transistor | Optocoupler |
|---|---|---|
| Cost | Low | High |
| Power consumption | Small | Large |
| Device size | Small | Large |
| Number of discrete devices | Few | Many |

A detailed description of the above table is as follows.
(1) Compared with optocouplers, the use of high-voltage MOS transistors in high-voltage sampling circuits can reduce costs.
   To intuitively reflect the cost advantage of high-voltage MOS transistors, this embodiment quantifies the cost through specific models. Taking TLX9160T optocoupler and STD4NK100Z high-voltage MOS transistor as examples, the cost of one TLX9160T optocoupler is about 14 yuan, and the cost of one STD4NK100Z high-voltage MOS transistor is about 5 yuan. Thus, replacing one TLX9160T optocoupler with one STD4NK100Z high-voltage MOS transistor can save 9 yuan. If multiple replacements and mass production are carried out, the cost reduction of the product is considerable.
(2) Power consumption of the high-voltage MOS transistor is smaller.
   A high-voltage MOS transistor is a voltage-controlled device, and its current consumption is very small, while an optocoupler needs to consume a relatively large current for normal operation.
(3) The size of the high-voltage MOS transistor is smaller.
   The small size of the high-voltage MOS transistor can reduce PCB footage. In the trend of increasingly miniaturized and integrated electronic devices, the PCB space saved by simplifying the circuit can reduce the product volume, optimize the layout, and has an advantage of improving product reliability.
   The length, width, and height of the high-voltage MOS transistor are 10.1mm * 6.6mm * 2.4mm; while the length, width, and height of the optocoupler are 10.5mm * 10.2mm * 2.55mm. It can be seen that in terms of size, the high-voltage MOS transistor is much smaller than the optocoupler.
(4) The number of discrete devices is smaller, which can simplify the circuit and reduce failure rate.
   In circuit design, more devices mean a higher risk of failure, that is, the more devices there are, the higher the probability of device aging or failure. Comparing FIG. 1 and FIG. 2, it can be seen that if a high-voltage MOS transistor is used to replace the optocoupler, the discrete devices used for driving will be reduced, the circuit will be simplified, and thus reliability will be improved.
(5) High-voltage MOS transistors have greater overcurrent capability and low on-resistance.

For example, overcurrent parameters:
MOS transistor: ID = 2.2A (25°C), ID = 1.0A (100°C);
Optocoupler: ION = 50mA (25°C), ION = 10mA (125°C).

On-resistance:
MOS transistor: R(DS)ON = 6.8Ω (VDS = 10V, ID = 1.1A, T = 25°C);
Optocoupler: RON = 250Ω (max) (ION = 50mA, IF = 10mA, T = 25°C).

From the above comparison, it can be seen that compared with optocouplers, high-voltage MOS transistors have greater overcurrent capability and low on-resistance, and can be driven by the AFE without the need to provide a separate battery for driving.

In conclusion, the high-voltage sampling circuit provided by the present disclosure can reduce costs, simplify the circuit, improve product reliability, and reduce product failure rates.

Based on a same inventive concept, the present disclosure also provides a high-voltage sampling method using the high-voltage sampling circuit described in the above embodiments. FIG. 4 is a schematic diagram of a high-voltage sampling method according to an embodiment of the present disclosure. As shown in FIG. 4, the method includes the following steps 401 and 402.

In step 401, in response to the battery sampling device receiving a high-voltage sampling instruction, control the output terminal to output a high level to turn on the gate-source of the high-voltage MOS transistor;

In step 402, use the analog-to-digital conversion terminal of the battery sampling device to collect the voltage across/passing through the high-voltage MOS transistor, and convert the voltage to obtain the supply voltage of the battery pack.

In some embodiments, the method further includes: in response to the battery sampling device receiving a current sampling instruction, collect the current passing through the shunt from the current sampling pin.

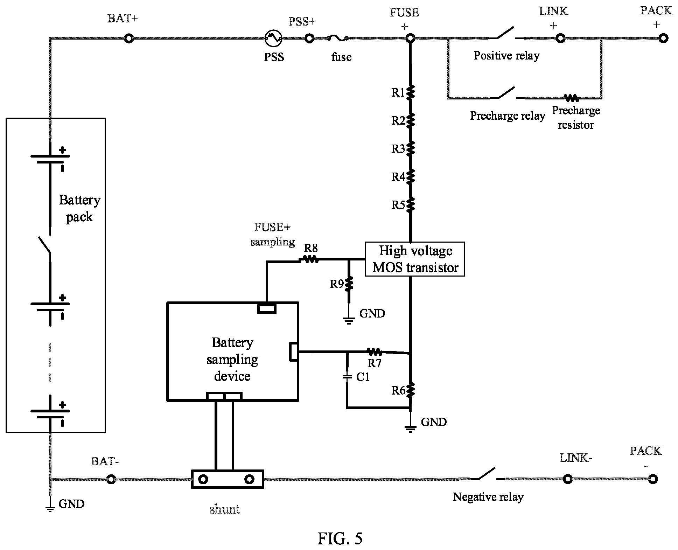

FIG. 5 is a specific schematic diagram of a high-voltage sampling circuit according to an embodiment of the present disclosure. As shown in FIG. 5, PSS, FUSE, and LINK therein are fuses, also known as safety fuses or fusible elements. They are electrical components used to ensure the safe operation of the circuit, and can also be understood as a type of short-circuit protector for short-circuit protection or severe overload protection. There are multiple paths for high-voltage sampling of the battery pack, and the sampling principle of each path is the same. FIG. 5 takes FUSE + sampling as an example. In FIG. 5, the first voltage-dividing resistor includes 5 sub-resistors, denoted as R1 to R5 respectively; the second voltage-dividing resistor is denoted as R6; the third voltage-dividing resistor is denoted as R8; the fourth voltage-dividing resistor is denoted as R9; the filter current-limiting resistor is denoted as R7; and the filter capacitor is denoted as C1.

When the Battery Management System (BMS) is powered on and enters working mode, the Battery Management Unit (BMU) sends an instruction to the AFE, operates the register of the AFE, and causes a GPO pin of the AFE to output a high level. The high level is divided by resistors R8 and R9 to turn on the high-voltage MOS transistor. Then, using the voltage division principle, the divided sampling voltage is filtered and transmitted to the AFE. The BMU reads the corresponding register value of the AFE through IsoSPI communication, converts the read value to obtain the supply voltage, and determines the next operation based on the obtained supply voltage.

The embodiments of the present disclosure also provide a battery management system, which includes the high-voltage sampling circuit described in any of the above embodiments. By using the high-voltage sampling circuit in the embodiments, on the premise of ensuring product performance, cost of the product can be significantly reduced, while the circuit is simplified, and the reliability and competitiveness of the product are improved.

At least one embodiment of the present disclosure provides a new energy vehicle applying the above battery management system. The high-voltage sampling circuit in the battery management system of the new energy vehicle uses a high-voltage MOS transistor as an electronic switch. The battery management system stores executable computer instructions, and when the computer instructions are executed, the high-voltage sampling method described in any implementation of the present disclosure can be implemented.

At least one embodiment of the present disclosure also proposes a computer-readable storage medium on which a computer program is stored, and when the program is executed by a processor, the high-voltage sampling method described in any of the present disclosure is implemented.

It should be understood by those skilled in the art that one or more embodiments of the present disclosure can be provided as a method, a system, or a computer program product. Therefore, one or more embodiments of the present disclosure can adopt the form of an entirely hardware embodiment, an entirely software embodiment, or an embodiment combining software and hardware aspects. Moreover, one or more embodiments of the present disclosure can adopt the form of a computer program product implemented on one or more computer-usable storage media (including but not limited to disk storage, CD-ROM, optical storage, etc.) containing computer-usable program codes.

The term "and/or" in the present disclosure means having at least one of the two. For example, "A and/or B" includes three schemes: A, B, and "A and B".

Each embodiment in the present disclosure is described in a progressive manner, and the same or similar parts between the various embodiments can be referred to each other. Each embodiment focuses on the differences from other embodiments. In particular, for the data processing device embodiment, since it is basically similar to the method embodiment, the description is relatively simple, and the relevant parts can be referred to the description of the method embodiment.

The specific embodiments of this specification have been described. Other embodiments are within the scope of the appended claims. In some cases, the actions or steps recorded in the claims can be executed in an order different from that in the embodiments and still achieve desired results. In addition, the processes depicted in the drawings do not necessarily require the specific order or sequential order shown to achieve the desired results. In some implementations, multitasking and parallel processing may be advantageous.

Although the present disclosure contains many specific implementation details, these should not be interpreted as limiting the scope of any invention or the scope of protection claimed, but rather as mainly describing the features of specific embodiments of a specific invention. Certain features described in multiple embodiments in the present disclosure can also be implemented in combination in a single embodiment. On the other hand, various features described in a single embodiment can also be implemented in multiple embodiments separately or in any suitable subcombination. In addition, although features may function in certain combinations as described above and even initially claimed as such, one or more features from the claimed combination can be removed from the combination in some cases, and the claimed combination may refer to a subcombination or a variation of a subcombination.

Similarly, although operations are depicted in a specific order in the drawings, this should not be understood as requiring these operations to be executed in the specific order shown or in sequential order, or that all illustrated operations must be executed to achieve the desired results. In some cases, multitasking and parallel processing may be advantageous. In addition, the separation of various system modules and components in the above embodiments should not be understood as requiring such separation in all embodiments, and it should be understood that the described program components and systems can usually be integrated together into a single software product or packaged into multiple software products.

Thus, specific embodiments of the subject matter have been described. Other embodiments are within the scope of the appended claims. In some cases, the actions recited in the claims can be performed in a different order and still achieve desirable results. Furthermore, the processes depicted in the accompanying drawings do not necessarily require the particular order shown, or sequential order, to achieve desirable results. In certain implementations, multitasking and parallel processing may be advantageous.

It should be noted that in the drawings, the sizes of layers and regions may be exaggerated for clarity of illustration. Moreover, it can be understood that when an element or layer is referred to as being "on" another element or layer, it can be directly on the other element or layer, or an intermediate layer may exist. In addition, it can be understood that when an element or layer is referred to as being "under" another element or layer, it can be directly under the other element or layer, or one or more intermediate layers or elements may exist. In addition, it can also be understood that when a layer or element is referred to as being "between" two layers or two elements, it can be the only layer between the two layers or two elements, or one or more intermediate layers or elements may also exist. Like reference numerals throughout indicate like elements.

In the present disclosure, the terms "first" and "second" are only used for descriptive purposes, and cannot be understood as indicating or implying relative importance. The term "plurality" refers to two or more, unless otherwise clearly defined.

Those skilled in the art will easily think of other implementations of the present disclosure after considering the specification and practicing the disclosure disclosed herein. The present disclosure is intended to cover any variations, uses, or adaptive changes of the present disclosure. These variations, uses, or adaptive changes follow the general principles of the present disclosure and include common knowledge or conventional technical means in the technical field not disclosed in the present disclosure. The specification and embodiments are only regarded as exemplary, and the true scope and spirit of the present disclosure are pointed out by the following claims.

It should be understood that the present application is not limited to the precise structures described above and shown in the drawings, and various modifications and changes can be made without departing from its scope. The scope of the present application is limited only by the appended claims.

## Claims

1. A high-voltage sampling circuit, configured to collect a voltage of a battery pack, a positive electrode of the battery pack is connected to a positive relay, a negative electrode of the battery pack is connected to a negative relay, and the circuit comprises: a high-voltage MOS transistor and a battery sampling device;
an output terminal of the battery sampling device is connected to a gate of the high-voltage MOS transistor and is configured to output a high level or a low level;
an analog-to-digital conversion terminal of the battery sampling device is connected to a source of the high-voltage MOS transistor and is configured to collect a voltage at the source of the high-voltage MOS transistor;
a drain of the high-voltage MOS transistor is connected to the positive electrode of the battery pack through a first voltage-dividing resistor, and the source of the high-voltage MOS transistor is connected to the negative electrode of the battery pack through a second voltage-dividing resistor; and
the battery sampling device is configured to, when outputting the high level to the high-voltage MOS transistor, collect a voltage passing through the high-voltage MOS transistor, and convert the voltage to obtain a supply voltage of the battery pack.

2. The circuit according to claim 1, wherein the gate of the high-voltage MOS transistor is connected to one end of a third voltage-dividing resistor, and other end of the third voltage-dividing resistor is connected to the output terminal of the battery sampling device; and
the gate of the high-voltage MOS transistor is connected to one end of a fourth voltage-dividing resistor, and other end of the fourth voltage-dividing resistor is grounded.

3. The circuit according to claim 1, wherein the circuit further comprises: a filter circuit configured to filter the voltage collected by the battery sampling device;
a filter current-limiting resistor in the filter circuit is connected in series between the source of the high-voltage MOS transistor and the analog-to-digital conversion terminal of the battery sampling device; and
one end of a filter capacitor in the filter circuit is connected to the analog-to-digital conversion terminal of the battery sampling device, and other end of the filter capacitor is grounded.

4. The circuit according to any one of claims 1 to 3, wherein the circuit further comprises: a shunt;
a first end of the shunt is connected to the negative electrode of the battery pack, a second end of the shunt is connected to the negative relay, and a third end of the shunt is connected to a current sampling pin of the battery sampling device; and
the battery sampling device is configured to collect a current passing through the shunt.

5. The circuit according to any one of claims 1 to 3, wherein the first voltage-dividing resistor comprises a plurality of sub-resistors, and the sub-resistors are connected in series; and respective resistance values of the sub-resistors are same and/or different, and a number and the respective resistance values of the sub-resistors are determined according to a voltage value to be divided.

6. The circuit according to any one of claims 1 to 3, wherein the high-voltage MOS transistor meets at least one of following conditions:
a source-drain voltage of the high-voltage MOS transistor is greater than the supply voltage of the battery pack;
a maximum gate-source voltage of the high-voltage MOS transistor is greater than the supply voltage of the battery pack; or
a distance between pins of the high-voltage MOS transistor is greater than a distance threshold.

7. A high-voltage sampling method using the high-voltage sampling circuit according to any one of claims 1-6, wherein the method comprises:
in response to the battery sampling device receiving a high-voltage sampling instruction, controlling an output terminal to output a high level to turn on the gate and source of the high-voltage MOS transistor; and
collecting a voltage passing through the high-voltage MOS transistor by using the analog-to-digital conversion terminal of the battery sampling device, and converting the voltage to obtain a supply voltage of the battery pack.

8. The method according to claim 7, wherein the method further comprises:
in response to the battery sampling device receiving a current sampling instruction, collecting a current passing through the shunt from a current sampling pin.

9. A battery management system, comprising the high-voltage sampling circuit according to any one of claims 1-6.
